# EUROPÄISCHE PATENTSCHRIFT

(11) **EP 2 807 908 B1**
(45) Veröffentlichungstag und Bekanntmachung des Hinweises auf die Patenterteilung: **13.03.2019**
(21) Anmeldenummer: 13701359.5
(22) Anmeldetag: 09.01.2013
(51) Int. Cl.: H05K 7/20

(54) **VORRICHTUNG, INSBESONDERE SCHALTSCHRANK, MIT GEHÄUSE**
APPLIANCE, ESPECIALLY SWITCHGEAR CABINET, HAVING A HOUSING
DISPOSISTIF, NOTAMMENT ARMOIRE DE COMMANDE, DOTÉ D'UN BOÎTIER

(30) Priorität: 23.01.2012 DE 102012001120
(43) Veröffentlichungstag der Anmeldung: 03.12.2014
(73) Patentinhaber: Sew-Eurodrive GmbH & Co. KG, 76646 Bruchsal (DE)
(72) Erfinder: SCHWESINGER, Klaus, 76646 Bruchsal (DE); SCHMIDT, Josef, 76676 Graben-Neudorf (DE)
(86) Internationale Anmeldenummer: PCT/EP2013/000037
(87) Internationale Veröffentlichungsnummer: WO 2013/110430

(56) Entgegenhaltungen:
- EP-A1- 0 103 412
- DE-A1- 2 638 118
- DE-A1-102004 012 737
- DE-A1-102005 017 770
- DE-A1-102008 060 613
- DE-A1-102009 024 370
- DE-A1-102010 005 303
- DE-C1- 4 015 030
- JP-A- 2002 057 479
- US-A1- 2005 286 226
- US-A1- 2009 284 923

## Beschreibung

Die Erfindung betrifft eine Vorrichtung, insbesondere Schaltschrank, mit Gehäuse.

Es ist allgemein bekannt, Elektrogeräte, die Wärme erzeugende Bauelemente aufweisen, in Schaltschränken einzumontieren, insbesondere an Hutschienen.

Aus der US 2005/286226 A1 ist eine Kühlanordnung für eine Wärme erzeugendes Element bekannt.

Aus der DE 10 2004 ist eine Vorrichtung zur Ableitung von Abwärme bekannt, die durch die Verwendung von Leistungshalbleitern in Kunststoff-Schweißextrudern zum direkten Anschluss an das Wechselstrom- oder Drehstromnetz entsteht.

Aus der EP 0 103 412 A1 ist ein Steuerapparat für Umrichter bekannt.

Aus der JP 2002057479 ist ein geschlossenes Gehäuse bekannt, welches mittels hohler Wärmesenkteile penetriert ist.

Der Erfindung liegt daher die Aufgabe zugrunde, eine verbesserte Entwärmung vorzusehen.

Erfindungsgemäß wird die Aufgabe bei der Modul nach den in Anspruch 1 und bei der Vorrichtung nach den in Anspruch 12 angegebenen Merkmalen gelöst.

Wichtige Merkmale bei dem Modul sind, dass das Modul, insbesondere ein Elektrogerät mit einer Kühlanordnung zur Entwärmung Wärme erzeugender Bauelemente, einen Kühlkörper aufweist und Wärme erzeugende Bauelemente,
wobei der Kühlkörper einen durchgehenden Hohlraum aufweist, welcher als Kühlkanal fungiert,

insbesondere wobei der Kühlkörper einstückig oder mehrstückig ausführbar ist insbesondere wobei der Kühlkörper als Stranggussteil ausgeführt ist.

Von Vorteil ist dabei, dass der Kühlkörper einen zentral durchgehenden Hohlraum aufweist und somit eine zentrale Belüftung des Kühlkörpers ermöglicht ist. Somit dient der Kühlkörper auch als Luftleitteil. Insbesondere ist somit der Hohlraum des Kühlkörpers als Verbindungskanal zweier Raumbereiche einsetzbar, so dass Luft vom einen Raumbereich durch den Hohlraum in den anderen Raumbereich förderbar ist. Die Förderung ist dabei konvektiv oder mittels Lüfter bewirkbar. Auf diese Weise sind an mehreren Seiten, an mehreren Stellen des Umfangs oder am gesamten Umfang Wärme erzeugende Bauelemente anordenbar und es ist eine effektive Entwärmung ausführbar.

Bei Ausführung als Stranggussteil sind in einfacher Weise am Kühlkörper Kühlrippen vorsehbar, welche in den Hohlraum des Kühlkörpers hineinragen und somit die zum Hohlraum hin gerichtete Innenoberfläche des Kühlkörpers vergrößern.

Bei einer vorteilhaften Ausgestaltung ist zumindest ein Wärme erzeugendes Bauelement an einem Außenflächenabschnitt des Kühlkörpers wärmeleitend verbunden, insbesondere berührt den Kühlkörper. Von Vorteil ist dabei, dass außen am Kühlkörper Wärme einleitbar und diese nur nach innen zum Hohlraum geleitet werden muss. Der Kühlkörper hat somit an seiner Innenseite Kühlrippen, welche in den Hohlraum hineinragen.

Bei einer vorteilhaften Ausgestaltung ist ein Wärme erzeugendes Bauelement auf einer Leiterplatte bestückt, insbesondere wobei seine elektrischen Anschlusselemente lötverbunden sind mit einem Leiterbahnabschnitt,

wobei die Leiterplatte mittels einer Haltevorrichtung mit dem Kühlkörper verbunden ist. Von Vorteil ist dabei, dass eine bestückte Leiterplatte in Richtung auf den Kühlkörper drückbar ist und dabei die Wärmeeinleitung in den Kühlkörper von den Wärme erzeugenden Bauelementen aus ausführbar ist.

Bei einer vorteilhaften Ausgestaltung ist die Haltevorrichtung ein auf die Leiterplatte drückendes elektrisches Isolierteil, welches von einer Halteplatte, insbesondere von einer metallischen Halteplatte, auf die Leiterplatte gedrückt ist,

insbesondere wobei die Halteplatte an den Kühlkörper angeschraubt oder von einem mit dem Kühlkörper schraubverbundenen Federelement an das Isolierteil angedrückt ist. Von Vorteil ist dabei, dass über die Halteplatte und das Isolierteil die Andrückkraft auf eine große Fläche aufspreizbar ist und somit ein geringer Anpressdruck von der Halteplatte mit dem Isolierteil auf die Leiterplatte bewirkt wird. Außerdem ist bei Verwendung von zwei oder mehr Schrauben eine räumliche Ausrichtung der Leiterplatte relativ zum Kühlkörper einfach ermöglicht. Mittels der Halteplatte und dem Isolierteil ist außerdem der Krafteintrag in die Leiterplatte an einem von den Schrauben entfernten Ort ausführbar.

Bei einer vorteilhaften Ausgestaltung sind die Halteplatte und das Isolierteil auf der vom Kühlkörper abgewandten Seite der Leiterplatte angeordnet. Von Vorteil ist dabei, dass eine möglichst optimale Ausnutzung der äußeren Oberfläche des Kühlkörpers bewirkbar ist.

Bei einer vorteilhaften Ausgestaltung ist die Leiterplatte eine Anordnung aus mittels flexibler Bereiche verbundenen Leiterplatten,

insbesondere wobei die Anordnung den Kühlkörper in Umfangsrichtung des Kühlkanals zumindest teilweise umgibt. Von Vorteil ist dabei, dass die Bestückung der Leiterplatten in einem einzigen Arbeitsgang ausführbar ist, obwohl die Leiterplatten im Modul nicht parallel zueinander ausgerichtet sind. Eine elektrische Verbindung der Leiterplatten zueinander ist außerdem über die flexiblen Bereiche schon vorhanden und ist somit nicht zusätzlich erforderlich.

Bei einer vorteilhaften Ausgestaltung weisen zumindest zwei mittels flexibler Bereiche verbundene Leiterplatten jeweils ein Wärme erzeugendes Bauelement auf, wobei jede der Leiterplatte ein über ein Isolierteil auf die Leiterplatte drückendes Halteteil aufweist, welches jeweils schraubverbunden ist mit dem Kühlkörper,
wobei jeweils Halteteil und Isolierteil auf der vom Kühlkörper abgewandten Seite der Leiterplatte angeordnet sind,
insbesondere wobei die beiden Wärmeerzeugenden Bauelemente auf gegenüberliegenden Seiten des Kühlkörpers angeordnet sind. Von Vorteil ist dabei, dass die Krafteinleitung in einfacher Weise an die Bestückung anpassbar ist, insbesondere indem das Isolierteil entsprechend dick ausgeführt wird und Ausnehmungen aufweist, in welchen Bauteile der Leiterplatte anordenbar sind, welche auf der vom Kühlkörper abgewandten Seite der Leiterplatte bestückt sind.

Bei einer vorteilhaften Ausgestaltung ist der Kühlkörper zur Verbesserung des Wärmeübergangs im Bereich der Kontaktfläche zum oder zu den Wärme erzeugenden Bauelemente vertieft und/oder feinbearbeitet, insbesondere geschliffen ist. Von Vorteil ist dabei, dass ein verbesserter Wärmeübergang ausgeführt ist.

Bei einer vorteilhaften Ausgestaltung ist das Wärme erzeugende Bauelement ein Leistungshalbleiter, insbesondere jeweils. Von Vorteil ist dabei, dass Leistungshalbleiter eines Wechselrichters und/oder eines Umrichters vorsehbar sind.

Bei einer vorteilhaften Ausgestaltung ist zumindest ein weiteres Wärme erzeugendes Bauelement, insbesondere eine Induktivität, deren Spulenkern, insbesondere Ferritteil, wärmeleitend verbunden, insbesondere angedrückt und/oder schraubverbunden, an den Kühlkörper. Von Vorteil ist dabei, dass nicht nur Leiterplatten-bestückte sondern zusätzlich auch weitere Bauelemente entwärmbar sind mittels des Kühlkörpers. Insbesondere ist ein Ferritteil mit dem Aluminium-Kühlkörper wärmeleitend verbindbar, wobei die Materialien verschiedene Wärmeausdehnungskoeffizienten haben.

Bei einer vorteilhaften Ausgestaltung ist die Durchgangsrichtung des Hohlraumes durch den Kühlkörper, insbesondere Stranggussrichtung, senkrecht zu den Normalen der Leiterplatten ausgerichtet. Von Vorteil ist dabei, dass die Leiterplatten am Außenumfangs des Kühlkörpers anordenbar sind, also sozusagen auch rundherum. Hierdurch ist eine kompakte Ausführung des Moduls ermöglicht.

Bei einer vorteilhaften Ausgestaltung sind Wärme erzeugende Bauelemente an mehreren ebenen Oberflächenabschnitten des Kühlkörpers wärmeleitend mit diesem verbunden, wobei Oberflächenabschnitte nicht parallel ausgerichtet sind und/oder wobei die Normalenrichtungen der Oberflächenabschnitte den Hohlraum durchdringen. Von Vorteil ist dabei, dass in Umfangsrichtung um die Durchgangsrichtung des Hohlraums durch den Kühlkörper herum Wärmeerzeugende Bauelemente beziehungswiese Leiterplatten anordenbar sind.

Wichtige Merkmale der Erfindung bei der Vorrichtung, insbesondere Schaltschrank, mit Gehäuse, sind, dass
das Gehäuse ein oder mehrere Module gehäusebildend umgibt und zumindest ein Luftleitteil umfasst,
**wobei** das beziehungsweise jedes Modul zentral belüftet ist, insbesondere also einen von einem Kühlmedium durchströmten, im Modul angeordneten Kühlkanal aufweist,
wobei die zentrale Belüftung, insbesondere der Kühlkanal, des oder jedes Moduls in einen innerhalb des Gehäuses angeordneten Sammelkanal, insbesondere Luftkanal, mündet,
wobei der Sammelkanal zu einem Luftleitteil, insbesondere Umlenkteil, des Gehäuses führt, wobei das Luftleitteil eine zur Umgebung hin gerichtete Öffnung aufweist.

Von Vorteil ist dabei, dass durch die Vielzahl von Modulen eine große entwärmte Oberfläche realisierbar ist und durch die zentrale Belüftung ebenfalls eine große Entwärmung realisierbar ist. Denn die zentrale Belüftung ermöglicht ein um den zugehörigen Kühlkanal herum gehendes Anordnen von zu entwärmenden Bauelementen. Die Bauelemente müssen also nicht in einer geraden Linie angeordnet werden sondern entlang einer gekrümmten Linie oder Fläche, die den Kühlkörper beziehungsweise dessen Kühlkanal zumindest teilweise umschließt.

Bei einer vorteilhaften Ausgestaltung erfolgt die Speisung der zentralen Belüftung aus einem von dem Gehäuse umgebenen Innenbereich der Vorrichtung. Von Vorteil ist dabei, dass ein druckausgleichender Innenbereich zum Speisen mehrerer gegebenenfalls unterschiedlich stark ansaugender zentraler Belüftungen verwendet wird. Somit sind also Lüfter bei den Modulen einsetzbar, deren Leistung von der jeweils benötigten beziehungsweise prognostizierten Leistung variiert. Hierbei hängt der Kühlluftstrom von der Leistung des Lüfters ab. Durch den großen Innenbereich der Vorrichtung ist ein Druckpuffer realisierbar.

Bei einer vorteilhaften Ausgestaltung weist das Gehäuse eine Ausnehmung auf, durch welche der Innenbereich mit einem Kühlmediumstrom speisbar ist,
insbesondere wobei in der Ausnehmung des Gehäuses ein Lüftergitter angeordnet ist. Von Vorteil ist dabei, dass nur eine einzige Ausnehmung durch ein Lüftergitter geschützt werden muss. Das Lüftergitter ist auch derart feinmaschig ausführbar, dass eine Filterung des Kühlluftstroms ausführbar ist, also entsprechend zu große Schmutzpartikel herausfilterbar sind aus dem Kühlluftstrom.

Bei einer vorteilhaften Ausgestaltung ist innerhalb des Gehäuses zwischen Innenbereich und Sammelkanal eine Montageplatte angeordnet,
insbesondere wobei der Innenbereich mittels einer Montageplatte vom Sammelkanal abgegrenzt ist. Von Vorteil ist dabei, dass eine Trennung der kühleren Luftbereiche von den wärmeren Abluftbereichen erreicht ist und somit eine effektivere Kühlung ausführbar ist.

Bei einer vorteilhaften Ausgestaltung sind die Module mit der Montageplatte verbunden, insbesondere von der Montageplatte gehalten sind, insbesondere schraubverbunden sind. Von Vorteil ist dabei, dass die die kühleren von den wärmeren Bereichen trennende Montageplatte auch als mechanische Haltevorrichtung fungiert.
Bei einer vorteilhaften Ausgestaltung ist das Luftleitteil als Stranggussteil gefertigt. Von Vorteil ist dabei, dass eine kostengünstige Herstellung ermöglicht ist, insbesondere aus Aluminium, welches einen geringen Wärmeleitwiderstand aufweist.

Bei einer vorteilhaften Ausgestaltung weist das Luftleitteil eine Grundplatte auf, an welcher dem Innenraum der Vorrichtung zugewandte Kühlrippen angeordnet sind,
insbesondere so dass der aus dem Sammelkanal ausströmende Kühlmediumstrom an den Kühlrippen entlang in die Umgebung herausgeleitet wird,
insbesondere wobei hierbei der Kühlmediumstrom umgelenkt wird, insbesondere von einer im Wesentlichen vertikalen in eine im Wesentlichen horizontale Richtung. Von Vorteil ist dabei, dass durch die Umlenkung ein geradliniges Eindringen von Schmutzpartikeln oder Flüssigkeiten verhinderbar ist, insbesondere auch bei ausgeschalteter Vorrichtung. Somit ist ein verbesserter Schutz für den Gehäuseinnenbereich erreicht. Außerdem muss das Kühlmedium dem Umlenkbereich des Umlenkteils folgen und strömt somit entlang einer großen Oberfläche bei geringem Bauvolumen des Umlenkteils. Insgesamt ist somit die Vorrichtung sehr kompakt ausführbar.

Bei einer vorteilhaften Ausgestaltung weist die Montageplatte eine dem jeweiligen Modul, insbesondere dessen zentraler Belüftung und/oder dessen Kühlkanal, zugeordnete, durch die Montageplatte durchgehende Ausnehmung auf, insbesondere zur Durchströmung mittels des Kühlmediumstroms. Von Vorteil ist dabei, dass eine Vielzahl von Modulen an der Montageplatte anordenbar ist. Somit sind sogar gleichartig ausgeführte Module einsetzbar, deren Ausgangsströme oder Ausgangsspannungen parallel schaltbar sind, so dass eine größere Leistung erzeugbar ist gemäß dem modulartigen Aufbau. Denn der Nutzer wählt die Anzahl der Module entsprechend der benötigten Leistung.

Es ist sogar eine Montageplatte mit einer größeren Anzahl von Ausnehmungen herstellbar als die Anzahl der eingesetzten Module. Auf diese Weise ist bei verschieden großen Leistungen, also einer verschiedenen Anzahl von Modulen, stets dieselbe Montageplatte verwendbar. Die nicht durch Module abgedeckten Ausnehmungen sind mit einem Verschließteil verschließbar, so dass die Trennfunktion zwischen kühlerer und wärmerer Luft erhalten bleibt..

Bei einer vorteilhaften Ausgestaltung ist der Innenbereich durch zumindest die Montageplatte, das Gehäuse und das Lüftergitter begrenzt
und/oder
der Sammelkanal ist durch zumindest die Montageplatte und das Gehäuse begrenzt. Von Vorteil ist dabei, dass eine einfache Abtrennung des Innenbereichs mit kühlerer Luft von dem Sammelkanal mit wärmerer Luft erreichbar ist.

Bei einer vorteilhaften Ausgestaltung weist das Modul einen Kühlkörper mit einem durchgehenden Hohlraum auf, welcher als Kühlkanal fungiert,
insbesondere wobei der Kühlkörper als Stranggussteil ausgeführt ist. Von Vorteil ist dabei, dass der Kühlkörper einstückig oder mehrstückig ausführbar ist und somit abhängig von den jeweiligen Anforderungen geteilt oder einstückig ausführbar ist. Außerdem ist eine große Außenfläche um den Kühlkanal herum erreichbar, so dass eine effektive Entwärmung erreichbar ist.

Bei einer vorteilhaften Ausgestaltung sind ein oder mehrere Wärme erzeugende Bauelemente an einem jeweiligen Außenflächenabschnitt wärmeleitend verbunden. Von Vorteil ist dabei, dass durch die zentrale Belüftung eine große Außenfläche kühlbar ist. Insbesondere ist die Außenfläche aus mehreren ebenen Flächenabschnitten zusammensetzbar, so dass diesen Abschnitten ebene Leiterplatten zuordenbar sind und die darauf angeordneten Wärme erzeugenden Bauelemente mit dem jeweiligen Außenflächenabschnitt in Wärme leitenden Kontakt bringbar sind.

Bei einer vorteilhaften Ausgestaltung ist ein Wärme erzeugendes Bauelement auf einer Leiterplatte bestückt, insbesondere wobei seine elektrischen Anschlusselemente lötverbunden sind mit einem Leiterbahnabschnitt,
wobei die Leiterplatte mittels einer Haltevorrichtung mit dem Kühlkörper verbunden ist. Von Vorteil ist dabei, dass die Haltevorrichtung auf der vom Kühlkörper abgewandten Seite der Leiterplatte anordenbar ist und nur beispielsweise schrauben durch die Leiterplatte hindurchführen zum Kühlkörper, so dass die Leiterplatte samt Bauelementen in Richtung auf den Kühlkörper zu drückbar ist.

Bei einer vorteilhaften Ausgestaltung ist die Haltevorrichtung ein auf die Leiterplatte Isolierteil, welches von einer Halteplatte, insbesondere von einer metallischen Halteplatte, auf die Leiterplatte gedrückt ist,
insbesondere wobei die Halteplatte an den Kühlkörper angeschraubt oder von einem mit dem Kühlkörper schraubverbundenen Federelement an das Isolierteil angedrückt ist. Von Vorteil ist dabei, dass hohe Kräfte auf die metallische und somit stabile Halteplatte einleitbar sind und die Andruckkraft somit über das Isolierteil auf die Leiterplatte beziehungsweise die darauf bestückten Bauelemente weiterleitbar ist.

Bei einer vorteilhaften Ausgestaltung ist die Leiterplatte eine Anordnung aus mittels flexibler Bereiche verbundenen Leiterplatten,
insbesondere wobei die Anordnung den Kühlkörper in Umfangsrichtung des Kühlkanals zumindest teilweise umgibt. Von Vorteil ist dabei, dass eine Leiterplattenanordnung den Kühlkörper umgebend vorsehbar ist und somit eine große Leiterplattenfläche effektiv kühlbar ist, also mit geringem Bauvolumen.

Bei einer vorteilhaften Ausgestaltung ist am Kühlkörper zumindest ein Luftleitteil angeordnet,
insbesondere wobei ein erstes Luftleitteil einen Lüfter umfasst und ein von dem ersten Luftleitteil mittels des Kühlkörpers beabstandetes Luftleitteil zum Halten des Kühlkörpers an der Montageplatte dient, insbesondere wobei das weitere Luftleitteil zwischen dem Kühlkörper und der Montageplatte angeordnet ist. Von Vorteil ist dabei, dass die Luftführung verbessert ist und außerdem ein Luftleitteil zur mechanischen Befestigung verwendbar ist. Hierbei ist eine formschlüssige Verbindung, insbesondere in Umfangsrichtung um den Kühlkanal des Moduls herum, zwischen Kühlkörper und Luftleitteil einfach ausführbar, indem der Kühlkörper nicht einen kreisrunden sondern einen polygonalen Querschnitt aufweist, also ebene Außenflächenabschnitte aufweist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von Abbildungen näher erläutert:
In der Figur 1 ist der Kühlkörper eines erfindungsgemäßen Moduls mit zentraler Belüftung in Schrägansicht gezeigt.
In der Figur 2 ist das Modul mit Leiterplattenabschnitten (23, 24, 25) gezeigt, auf welchen die Wärme erzeugenden elektronischen Bauelemente, insbesondere Leistungshalbleiter, bestückt sind.
In der Figur 3 ist eine zugehörige Schnittansicht gezeigt.
In der Figur 4 ist eine Schrägansicht eines mehrere solche Module aufnehmendes Gehäuses, insbesondere Schaltschrankgehäuses, gezeigt.
In der Figur 5 ist eine zugehörige Schnittansicht gezeigt.

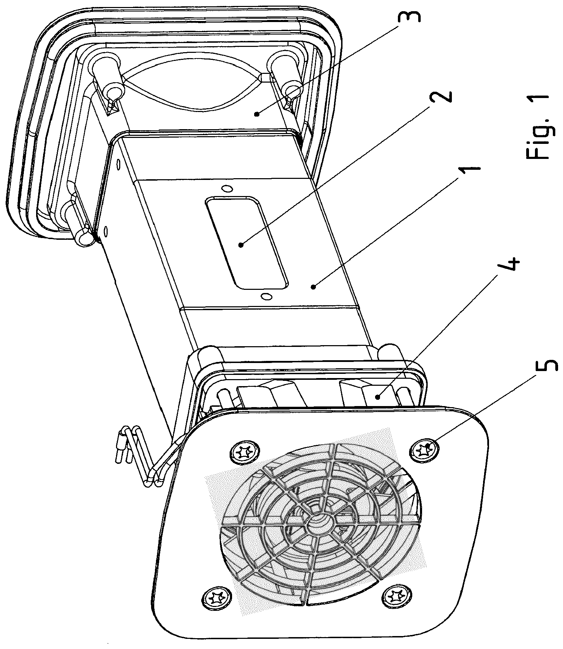

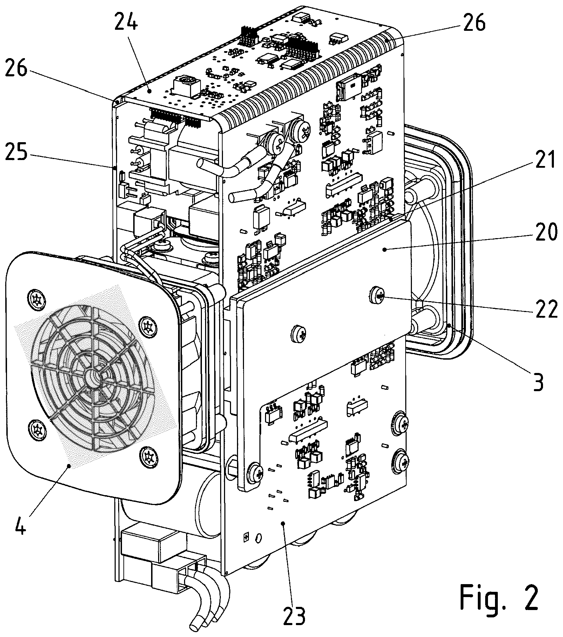

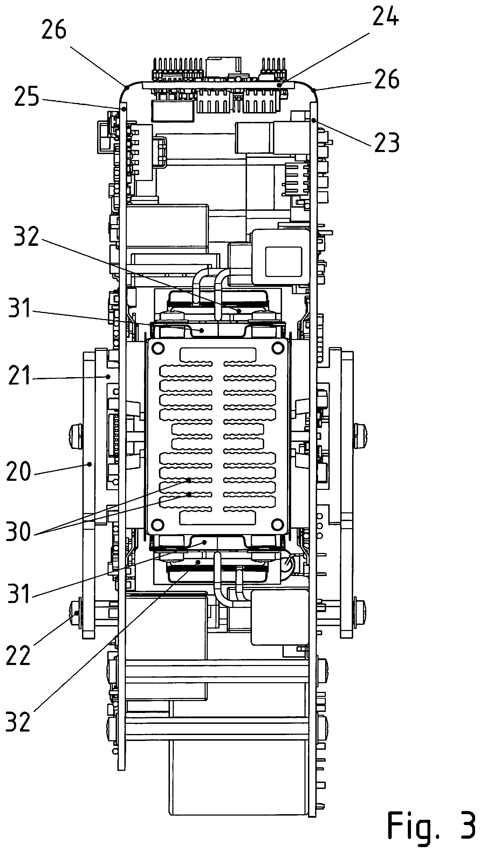

Wie in den Figuren 1 bis 3 gezeigt, weist das Modul eine zentrale Belüftung zum Entwärmen der von den Wärmeerzeugenden Bauelementen erzeugten Wärme auf. Hierzu ist ein Kühlkörper 1 vorgesehen, der als einstückig oder mehrstückig ausgeführtes Stranggussteil gefertigt ist.

Dieser Kühlkörper 1 ist hohl ausgeführt und weist in den Hohlraum hinein ragende Kühlrippen 30 auf. Somit ist die Hohlraumoberfläche vergrößert und der Wärmeübergangswiderstand vom Kühlkörper 1 zum den Hohlraum durchströmenden Kühlmedium, insbesondere Kühlluft, verringert.

Da der Kühlkörper 1 ein Stranggussteil ist, insbesondere ein Aluminium-Stranggussteil, ist der Hohlraum durchgehend und die Kühlrippen 30 sowie der Hohlraum verlaufen in Stranggussrichtung.

Der Kühlkörper ist beispielhaft als Quader ausgeführt und weist somit vier in etwa ebene Seitenflächen auf. Zur Kontaktierung der Wärme erzeugenden Bauelemente weisen zumindest zwei Seitenflächen, insbesondere die zwei sich diametral gegenüber stehenden Seitenflächen, Kontaktflächen 2 auf, die fein bearbeitet sind, insbesondere also gefräst und/oder geschliffen und/oder sandgestrahlt oder dergleichen. Somit sind die Bauelemente an die Kontaktfläche andrückbar, insbesondere mit zwischengeordneter Wärmeleitpaste, und ein guter Wärmeübergang erreichbar.

An die beiden anderen Seitenflächen ist jeweils ein Ferritteil 31 angedrückt oder sonstig verbunden, so dass die von einer Wicklung 32 erzeugte Wärme über den Ferrit 31 an den Kühlkörper 1 leitbar ist. Dabei ist das Ferritteil 31 als Spulenkern der Wicklung 32 verwendet, so dass also das von der Wicklung 32 erzeugte Magnetfeld vom Ferritteil 31 gebündelt und geleitet wird.

Die Wicklung ist als Induktivität eines DC-DC Wandlers verwendet, also als Booster-Drossel eines DC-DC -Boosters.

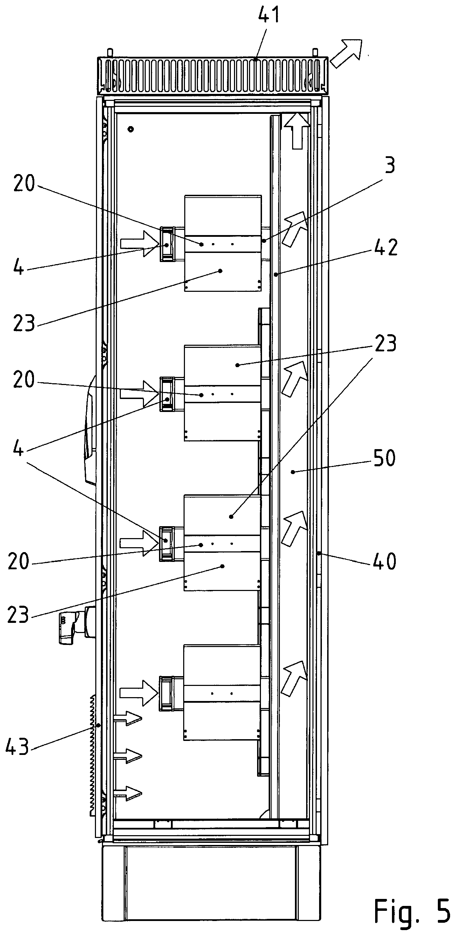

Der Hohlraum des Kühlkörpers 1 mündet an seiner ersten Öffnung in Stranggussrichtung in ein Luftleitteil 3, welches aus Kunststoff gefertigt ist und auf den Kühlkörper 1 aufgesteckt ist. Außerdem weist das Luftleitteil 3 an seinem von dem Kühlkörper 1 abgewandten Endbereich einen Flansch auf, mit dem es an einer Montageplatte 42 anschraubbar ist. Die Montageplatte 42 weist einen Ausnehmung auf, so dass das Kühlmedium nach Durchströmen des Kühlkörpers 1 und des Luftleitteils 3 die Ausnehmung der Montageplatte 42 durchströmt und in einen in Figur 5 gezeigten Luftkanal 50 einströmt.

Auf seinem von dem Luftleitteil 3 abgewandten Endbereich mündet der Hohlraum des Kühlkörpers 1 in ein Luftleitteil 4, in welchem ein Lüfter angeordnet ist.

Die Ferritteile 31 sind vorzugsweise schraubverbunden mit dem Kühlkörper 1 und somit angedrückt an diesen oder von einem mit dem Kühlkörper 1 schraubverbundenen Teil an den Kühlkörper 1 angedrückt.

Die Wärme erzeugenden Bauelemente sind auf einer der Leiterplatten (23, 25) bestückt. Diese Leiterplatten (23, 25) sind Teil einer flexiblen Leiterplattenanordnung. Hierbei sind die Leiterplatten (23, 24, 25) über zwischengeordnete flexible Bereiche 26 verbunden. Zur Herstellung dieser Leiterplattenanordnung wird von einer großen Leiterplatte das Trägermaterial, insbesondere Epoxidharz, in einem jeweiligen Teilbereich mechanisch herausgelöst, insbesondere herausgefräst, oder chemisch herausgelöst. Somit verbleiben in diesen nun als flexible Bereiche 26 fungierenden Teilbereichen nur noch die metallischen Leiterbahnen und eine jeweilige diese tragende Folie.
Die Leiterplattenanordnung sind somit um den Kühlkörper 1 herum gewunden, so dass die Wärme erzeugenden Bauelemente an den Kontaktflächen 2 der sich gegenüber angeordneten Außenflächen des Kühlkörpers 1 andrückbar sind.

Auf der zwischen den Leiterplatten (23, 25) zwischengeordneten Leiterplatte 24 ist die Induktivität eines DC-DC-Boosters angeordnet, deren Spulenkern, insbesondere Ferritteil 31, wärmeleitend verbunden, insbesondere angedrückt ist, an den Kühlkörper 1.

Auch auf der hierzu gegenüber angeordneten Außen-Seitenfläche ist eine ebensolche Induktivität eines oder des DC-DC-Boosters angeordnet, deren Spulenkern, insbesondere Ferritteil, wärmeleitend verbunden, insbesondere angedrückt ist, an den Kühlkörper 1.

Somit ist eine leistungsfähige Entwärmung der Wärme erzeugenden Bauelemente der elektronischen Schaltung erreicht. Insbesondere sind hierbei als Wärme erzeugende Bauelemente Leistungshalbleiterschalter und Spulenkerne der Wicklungen 32 beispielhaft erwähnt. Diese Wärme erzeugenden Bauelemente sind also jeweils auf der dem Kühlkörper 1 zugewandten Seite der jeweiligen Leiterplatte (23, 24, 25) angeordnet.

Mittels des Lüfters ist ein Kühlluftstrom antreibbar, so dass die Entwärmung sehr effektiv ausführbar ist. Aber auch ohne Lüfter ist eine konvektiv angetriebene Strömung vorhanden und bewirkt eine Entwärmung.

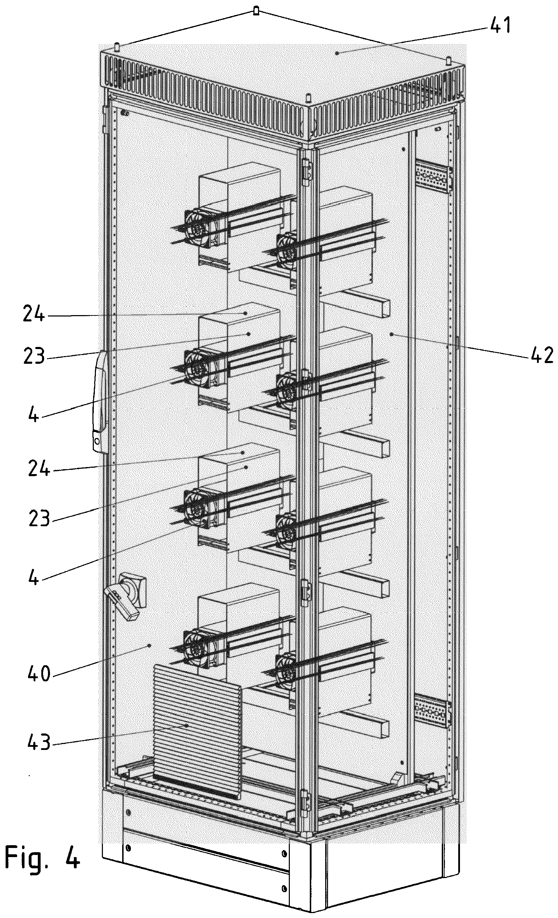

Wie in Figur 4 und 5 gezeigt, sind in einem Schaltschrank 40 mehrere wie in den Figuren 1 bis 3 zuvor beschriebene Module an einer Montageplatte 42 anordenbar, wobei die Montageplatte 42 zur zentralen Belüftung der jeweiligen Module eine jeweilige durchgehende Ausnehmung aufweist.

Somit mündet ein jeweiliger durch die Luftleitteile (3, 4) und den Hohlraum des Kühlkörpers 1 sowie durch die Ausnehmung in der Montageplatte 42 hindurchführender Kühlkanal in dem im Schaltschrank 40 vertikal hinaufführenden Luftkanal 50, welcher in ein Umlenkteil 41 mündet. Der Luftkanal 50 verläuft dabei innerhalb des Schaltschrankes 40. Das an der Oberseite des Schaltschrankes 40 angeordnete Umlenkteil weist eine zum Luftkanal 50 hin gerichtete Öffnung auf, die an einer an der Oberseite des Umlenkteils 41 angeordnete, horizontal verlaufende Grundplatte umgelenkt wird von der vertikalen in die horizontale Richtung.
Hierbei ist das Umlenkteil 41 vorzugsweise als Stranggussteil ausgeführt, so dass an der Grundplatte des Umlenkteils 41 Kühlrippen ausgeformt sind. Auf diese Weise gibt das vorbei strömende Kühlmedium Wärme ab an das Umlenkteil 41, welches dann zumindest auch an seiner Oberseite Wärme an die Umgebung, insbesondere Umgebungsluft, abführt.

Somit wird der Kühlluftstrom durch die Kühlkanäle der zentral belüfteten Module und durch die Montageplatte 42 geleitet, insbesondere in horizontaler Richtung bei vertikaler Ausrichtung der Montageplatte 42.

Die von den Lüftern in den Luftleitteilen 4 der Module angesaugte Luft wird von außen durch ein in der Gehäusewand des Schaltschrankes 40 vorgesehenes Lüftergitter 43 ins Gehäuseinnere geleitet und von dort von den Lüftern angesaugt.

Die Montageplatte 42 trennt also das Gehäuseinnere von dem Luftkanal 50 und somit die kühlere Luft von der wärmeren Abluft der Module.

Das jeweilige Modul ist mittels seines Luftleitteils 3 gehalten an der Montageplatte 42. Hierbei sind vorzugsweise an der der Montageplatte 42 zugewandten Seite Gewindebohrungen in dem Luftleitteil 3 eingebracht, so dass das Luftleitteil 3 mittels Schrauben an die Montageplatte anschraubbar ist. Bevorzugt gehen hierbei die Schrauben durch die Montageplatte 42.

Statt Luft ist auch ein anderes Kühlmedium verwendbar.

Mittels der zur Oberseite hin abdeckend wirksamen Grundplatte des Umlenkteils 41 ist ein Hereinfallen von Schmutzpartikeln in den Luftkanal 50 verhinderbar.

In der Figur 5 ist die Strömung des Kühlmediums durch Pfeile verdeutlicht.

In der Figur 4 sind die elektrischen Versorgungsleitungen, Datenbusleitungen und Ausgangsleitungen der Module mit jeweiligen schwarzen Linien angedeutet.

Somit ist in den Figuren 4 und 5 nun ein Schaltschrankgehäuse, in welchem eine Vielzahl von zentral belüfteten Modulen anordenbar und entwärmbar sind.

Die jeweiligen Module sind entweder alle gleichartig ausgeführt oder unterschiedlich zu zumindest einem der Module.

Die konkrete Ausführung nach Figur 1 bis 3 ist beispielhaft. Bei erfindungsgemäßen Ausführungsbeispielen ist wichtig, dass zentral im Modul ein hohler Kühlkörper, insbesondere Stranggussteil, angeordnet ist, an dessen Außenseite Wärme erzeugende Bauelemente wärmeleitend verbunden sind. Dabei sind diese Bauelemente auf derselben Leiterplatte bestückt oder jeweils auf separaten, also voneinander beabstandeten, miteinander nicht verbundenen Leiterplatten. Wenn die Leiterplatten miteinander verbunden sind, sind sie beispielhaft in der nach Figur 1 bis 3 gezeigten Weise verbunden, also über zwischengeordnete flexible Bereiche. Die Ausführung der flexiblen Bereiche als Teilbereiche einer ursprünglichen großen Leiterplatte, welche alle Leiterplatten des Moduls sowie die flexiblen Bereiche umfasst, ist nicht zwingend. Alternativ oder zusätzlich dürfen die flexiblen Bereiche nämlich auch als Gelenkteile ausgeführt werden, insbesondere also als Scharniere oder drehbare Verbindungselemente.

Beim Anschrauben der Halteplatte 20 an den Kühlkörper 1 mit den Schrauben 22 wird die Halteplatte 20 auf das Isolierteil 21 gedrückt, welches wiederum auf die von dem Kühlkörper 1 abgewandte Seite der Leiterplatte 23 drückt. Auf diese Weise wird diese Leiterplatte 23 zum Kühlkörper 1 hin gedrückt und somit auch die auf ihrer dem Kühlkörper 1 zugewandten Seite angeordneten Wärme erzeugenden Bauelemente, insbesondere Leistungshalbleiter eines Wechselrichters.

Bei einem weiteren erfindungsgemäßen Ausführungsbeispiel ist statt eines quaderförmigen, vier, in etwa ebene Außen-Seitenflächen aufweisenden Kühlkörpers ein polygonaler Kühlkörper verwendet, der drei, fünf, sechs oder mehr, in etwa ebene Außen-Seitenflächen aufweist.

Bei einem weiteren erfindungsgemäßen Ausführungsbeispiel ist statt des Schaltschrankgehäuses ein anderes Gehäuse verwendet, wobei statt des Lüftergitters 43 entweder eine Ausnehmung im Gehäuse anordenbar ist. Außerdem ist statt des Umlenkteils 41 auch ein anderes Luftleitteil verwendbar, beispielsweise ein Absaugrohr, welches mit dem Luftkanal 50 verbunden ist, oder ein Luftleitteil, das den Kühlluftstrom des Luftkanals 50 in eine andere Richtung lenkt.

### B zugsz ich nlist

1 Kühlkörper
2 Kontaktfläche
3 Luftleitteil
4 Luftleitteil
5 Schraube
20 Halteplatte, insbesondere metallisch
21 Isolierteil
22 Schraube
23 Leiterplatte
24 Leiterplatte
25 Leiterplatte
26 flexibler Bereich
30 Kühlrippen
31 Ferritteil
32 Wicklung
40 Schaltschrank
41 Umlenkteil
42 Montageplatte
43 Lüftergitter
50 Luftkanal

## Patentansprüche

1. Modul,
wobei das Modul eine Leiterplattenanordnung, einen Kühlkörper (1) aufweist und Wärme erzeugende Bauelemente,
wobei der Kühlkörper (1) einen durchgehenden Hohlraum aufweist, welcher als Kühlkanal fungiert,
wobei die Leiterplattenanordnung eine Anordnung aus mittels flexibler Bereiche (26) verbundenen Leiterplatten (23, 24, 25) ist,
wobei die Anordnung den Kühlkörper (1) in Umfangsrichtung des Kühlkanals zumindest teilweise umgibt,
wobei zwei mittels flexibler Bereiche (26) verbundene Leiterplatten (23, 24, 25) jeweils ein Wärme erzeugendes Bauelement aufweisen, wobei jede der Leiterplatte (23, 24, 25) eine über ein Isolierteil (21) auf die Leiterplatte (23, 24, 25) drückende Halteplatte (20) aufweist, welche jeweils schraubverbunden ist mit dem Kühlkörper (1), wobei jeweils Halteplatte (20) und Isolierteil (21) auf der vom Kühlkörper (1) abgewandten Seite der Leiterplatte (23, 24, 25) angeordnet sind,
wobei die beiden Wärmeerzeugenden Bauelemente auf gegenüberliegenden Seiten des Kühlkörpers (1) angeordnet sind.

2. Modul nach Anspruch 1,
**dadurch gekennzeichnet, dass**
zumindest ein Wärme erzeugendes Bauelement an einem Außenflächenabschnitt des Kühlkörpers (1) wärmeleitend verbunden ist.

3. Modul nach einem der vorangegangenen Ansprüche,
**dadurch gekennzeichnet, dass**
ein Wärme erzeugendes Bauelement auf einer Leiterplatte (23, 24, 25) bestückt ist,
wobei die Leiterplatte (23, 24, 25) mittels einer Haltevorrichtung mit dem Kühlkörper (1) verbunden ist.

4. Modul nach Anspruch 3,
**dadurch gekennzeichnet, dass**
die Haltevorrichtung ein auf die Leiterplatte (23, 24, 25) drückendes elektrisches Isolierteil (21) ist, welches von einer metallischen Halteplatte (20) auf die Leiterplatte (23, 24, 25) gedrückt ist,

5. Modul nach Anspruch 4,
**dadurch gekennzeichnet, dass**
die Halteplatte (20) und das Isolierteil (21) auf der vom Kühlkörper (1) abgewandten Seite der Leiterplatte (23, 24, 25) angeordnet sind.

6. Modul nach einem der vorangegangenen Ansprüche,
**dadurch gekennzeichnet, dass**
der Kühlkörper (1) zur Verbesserung des Wärmeübergangs im Bereich (26) der Kontaktfläche (2) zum oder zu den Wärme erzeugenden Bauelementen vertieft und/oder feinbearbeitet ist.

7. Modul nach einem der vorangegangenen Ansprüche,
**dadurch gekennzeichnet, dass**
am Kühlkörper (1) zumindest ein Luftleitteil (3, 4) angeordnet ist,
wobei ein erstes Luftleitteil (3, 4) einen Lüfter umfasst und ein von dem ersten Luftleitteil (3, 4) mittels des Kühlkörpers (1) beabstandetes Luftleitteil (3, 4) zum Halten des Kühlkörpers (1) an einer Montageplatte (42) dient, wobei das weitere Luftleitteil (3, 4) zwischen dem Kühlkörper (1) und der Montageplatte (42) angeordnet ist.

8. Modul nach einem der vorangegangenen Ansprüche,
**dadurch gekennzeichnet, dass**
das Wärme erzeugende Bauelement ein Leistungshalbleiter ist, dass
zumindest ein weiteres Wärme erzeugendes Bauelement vorhanden ist, wie eine Induktivität, deren Spulenkern an dem Kühlkörper (1) wärmeleitend verbunden ist.

9. Modul nach einem der vorangegangenen Ansprüche,
**dadurch gekennzeichnet, dass**
die Durchgangsrichtung des Hohlraumes durch den Kühlkörper (1) senkrecht zu den Normalenrichtungen der Leiterplatten (23, 24, 25) ausgerichtet ist.

10. Modul nach einem der vorangegangenen Ansprüche,
**dadurch gekennzeichnet, dass**
Wärme erzeugende Bauelemente an mehreren ebenen Oberflächenabschnitten des Kühlkörpers (1) wärmeleitend mit diesem verbunden sind, wobei Oberflächenabschnitte nicht parallel ausgerichtet sind und/oder wobei die Normalenrichtungen der Oberflächenabschnitte den Hohlraum durchdringen.

11. **Schaltschrank (40)** mit Gehäuse,
wobei das Gehäuse ein oder mehrere Module nach einem der vorangegangenen Ansprüche gehäusebildend umgibt und zumindest ein Luftleitteil (3, 4) umfasst,
wobei das beziehungsweise jedes Modul zentral belüftet ist, also einen von einem Kühlmedium durchströmten, im Modul angeordneten Kühlkanal aufweist,
wobei die zentrale Belüftung, des oder jedes Moduls in einen innerhalb des Gehäuses angeordneten Sammelkanal mündet,
wobei der Sammelkanal zu einem Luftleitteil (3, 4), des Gehäuses führt, wobei das Luftleitteil (3, 4) eine zur Umgebung hin gerichtete Öffnung aufweist,
wobei das Modul eine Leiterplattenanordnung, einen Kühlkörper (1) aufweist und Wärme erzeugende Bauelemente,
wobei der Kühlkörper (1) einen durchgehenden Hohlraum aufweist, welcher als Kühlkanal fungiert,
wobei die Leiterplattenanordnung eine Anordnung aus mittels flexibler Bereiche (26) verbundenen Leiterplatten (23, 24, 25) ist,
wobei die Anordnung den Kühlkörper (1) in Umfangsrichtung des Kühlkanals zumindest teilweise umgibt,
wobei zwei mittels flexibler Bereiche (26) verbundene Leiterplatten (23, 24, 25) jeweils ein Wärme erzeugendes Bauelement aufweisen, wobei jede der Leiterplatte ein über ein Isolierteil (21) auf die Leiterplatte drückendes Halteteil aufweist, welches jeweils schraubverbunden ist mit dem Kühlkörper (1). wobei jeweils Halteteil und Isolierteil (21) auf der vom Kühlkörper (1) agbewandten Seite der Leiterplatte angeordnet sind,
wobei die beiden Wärmeerzeugenden Bauelemente auf gegenüberliegenden Seiten des Kühlkörpers (1) angeordnet sind.

12. Schaltschrank (40) nach Anspruch 11
**dadurch gekennzeichnet, dass**
die Speisung der zentralen Belüftung aus einem von dem Gehäuse umgebenen Innenbereich der Vorrichtung erfolgt,
und dass
das Gehäuse eine Ausnehmung aufweist, durch welche der Innenbereich mit einem Kühlmediumstrom speisbar ist,

13. Schaltschrank (40) nach einem der Ansprüche 12 oder 11,
**dadurch gekennzeichnet, dass**
innerhalb des Gehäuses zwischen Innenbereich und Sammelkanal eine Montageplatte (42) angeordnet ist,
wobei der Innenbereich mittels einer Montageplatte (42) vom Sammelkanal abgegrenzt ist,
und dass
die Module mit der Montageplatte (42) verbunden sind.

14. Schaltschrank (40) nach einem der Ansprüche 11, 12 oder 13,
**dadurch gekennzeichnet, dass**
das Luftleitteil (3, 4) eine Grundplatte aufweist, an welcher dem Innenraum der Vorrichtung zugewandte Kühlrippen (30) angeordnet sind,
so dass der aus dem Sammelkanal ausströmende Kühlmediumstrom an den Kühlrippen (30) entlang in die Umgebung herausgeleitet wird,
wobei hierbei der Kühlmediumstrom umgelenkt wird, insbesondere von einer im Wesentlichen vertikalen in eine im Wesentlichen horizontale Richtung,

15. Schaltschrank (40) nach einem der Ansprüche 11 bis 14,
**dadurch gekennzeichnet, dass**
die Montageplatte (42) eine dem jeweiligen Modul, zugeordnete, durch die Montageplatte (42) durchgehende Ausnehmung aufweist,
wobei der Innenbereich durch zumindest die Montageplatte (42), das Gehäuse und das Lüftergitter (43) begrenzt ist
wobei der Sammelkanal durch zumindest die Montageplatte (42) und das Gehäuse begrenzt ist.

## Claims

1. Module,
wherein the module has a printed circuit board array, a heat sink (1) and heat-generating components,
wherein the heat sink (1) has a continuous cavity which acts as a cooling channel,
wherein the printed circuit board array is an array of printed circuit boards (23, 24, 25) connected by flexible regions (26),
wherein the array at least partially surrounds the heat sink (1) in the circumferential direction of the cooling channel, wherein two printed circuit boards (23, 24, 25) connected by flexible regions (26) each have a heat-generating component, wherein each of the printed circuit boards (23, 24, 25) has a retaining plate (20) which presses against the printed circuit board (23, 24, 25) via an insulating part (21), said retaining plate in each case being screw-connected to the heat sink (1), wherein in each case the retaining plate (20) and the insulating part (21) are arranged on the side of the printed circuit board (23, 24, 25) that is remote from the heat sink (1),
wherein the two heat-generating components are arranged on opposite sides of the heat sink (1).

2. Module according to claim 1,
**characterized in that**
at least one heat-generating component is connected to an outer surface section of the heat sink (1) in a heat-conducting manner.

3. Module according to one of the preceding claims,
**characterized in that**
a heat-generating component is mounted on a printed circuit board (23, 24, 25),
wherein the printed circuit board (23, 24, 25) is connected to the heat sink (1) by means of a retaining device.

4. Module according to claim 3,
**characterized in that**
the retaining device is an electrical insulating part (21) which presses against the printed circuit board (23, 24, 25) and which is pressed against the printed circuit board (23, 24, 25) by a metal retaining plate (20).

5. Module according to claim 4,
**characterized in that**
the retaining plate (20) and the insulating part (21) are arranged on the side of the printed circuit board (23, 24, 25) that is remote from the heat sink (1).

6. Module according to one of the preceding claims,
**characterized in that**
the heat sink (1) is recessed and/or precision-machined in order to improve the heat transfer in the region (26) of the area of contact (2) with the heat-generating component(s).

7. Module according to one of the preceding claims,
**characterized in that**
at least one air-conducting part (3, 4) is arranged on the heat sink (1),
wherein a first air-conducting part (3, 4) comprises a fan, and an air-conducting part (3, 4) that is spaced apart from the first air-conducting part (3, 4) by means of the heat sink (1) serves for retaining the heat sink (1) on a mounting plate (42), wherein the further air-conducting part (3, 4) is arranged between the heat sink (1) and the retaining plate (42).

8. Module according to one of the preceding claims,
**characterized in that**
the heat-generating component is a power semiconductor,
and **in that** there is
at least one further heat-generating component, such as an inductance, the coil core of which is connected to the heat sink (1) in a heat-conducting manner.

9. Module according to one of the preceding claims,
**characterized in that**
the direction in which the cavity extends through the heat sink (1) is oriented perpendicular to the normal directions of the printed circuit boards (23, 24, 25).

10. Module according to one of the preceding claims,
**characterized in that**
heat-generating components on a plurality of flat surface sections of the heat sink (1) are connected to the latter in a heat-conducting manner, wherein surface sections are not oriented in a parallel manner, and/or wherein the normal directions of the surface sections pass through the cavity.

11. Switchgear cabinet (40) comprising a casing,
wherein the casing encloses one or more modules according to one of the preceding claims in such a way as to form a housing and comprises at least one air-conducting part (3, 4),
wherein the or each module is centrally ventilated, that is to say has a cooling channel which is arranged in the module and through which a cooling medium flows,
wherein the central ventilation of the or each module opens into a collecting channel arranged within the casing,
wherein the collecting channel leads to an air-conducting part (3, 4) of the casing, wherein the air-conducting part (3, 4) has an opening directed towards the environment,
wherein the module has a printed circuit board array, a heat sink (1) and heat-generating components,
wherein the heat sink (1) has a continuous cavity which acts as a cooling channel,
wherein the printed circuit board array is an array of printed circuit boards (23, 24, 25) which are connected by flexible regions (26),
wherein the array at least partially surrounds the heat sink (1) in the circumferential direction of the cooling channel, wherein two printed circuit boards (23, 24, 25) connected by flexible regions (26) each have a heat-generating component, wherein each of the printed circuit boards has a retaining part which presses against the printed circuit board via an insulating part (21), said retaining part in each case being screw-connected to the heat sink (1),
wherein in each case the retaining part and the insulating part (21) are arranged on the side of the printed circuit board that is remote from the heat sink (1),
wherein the two heat-generating components are arranged on opposite sides of the heat sink (1).

12. Switchgear cabinet (40) according to claim 11,
**characterized in that**
the central ventilation is supplied from an inner region of the device, which is enclosed by the casing,
and **in that**
the casing has an aperture, through which a flow of cooling medium can be supplied to the inner region.

13. Switchgear cabinet (40) according to one of claims 12 or 11,
**characterized in that**
a mounting plate (42) is arranged within the casing between the inner region and the collecting channel,
wherein the inner region is delimited from the collecting channel by means of a mounting plate (42),
and **in that**
the modules are connected to the mounting plate (42).

14. Switchgear cabinet (40) according to one of claims 11, 12 or 13,
**characterized in that**
the air-conducting part (3, 4) comprises a baseplate, on which cooling ribs (30) are arranged in a manner facing towards the interior of the device,
such that the flow of cooling medium flowing out from the collecting channel is conducted along the cooling ribs (30) into the environment,
wherein the flow of cooling medium is thereby deflected, in particular from a substantially vertical direction to a substantially horizontal direction.

15. Switchgear cabinet (40) according to one of claims 11 to 14,
**characterized in that**
the mounting plate (42) has an aperture which extends through the mounting plate (42) and which is assigned to the respective module,
wherein the inner region is bounded by at least the mounting plate (42), the casing and the fan grille (43),
wherein the collecting channel is bounded by at least the mounting plate (42) and the casing.

## Revendications

1. Module,
sachant que le module présente un agencement de cartes imprimées, un corps de refroidissement (1) et des composants générant de la chaleur,
sachant que le corps de refroidissement (1) présente une cavité continue qui joue le rôle de canal de refroidissement,
sachant que l'agencement de cartes imprimées est un agencement de cartes imprimées (23, 24, 25) reliées au moyen de régions flexibles (26),
sachant que l'agencement entoure au moins partiellement le corps de refroidissement (1) dans la direction périphérique du canal de refroidissement,
sachant que deux cartes imprimées (23, 24, 25) reliées au moyen de régions flexibles (26) présentent chacune un composant générant de la chaleur, sachant que chacune des cartes imprimées (23, 24, 25) présente une plaque de maintien (20) exerçant une pression sur la carte imprimée (23, 24, 25) par l'intermédiaire d'un élément isolant (21), plaque qui est respectivement reliée par vissage au corps de refroidissement (1),
sachant que la plaque de maintien (20) et l'élément isolant (21) sont respectivement disposés sur des côtés de la carte imprimée (23, 24, 25) qui sont éloignés du corps de refroidissement (1),
sachant que les deux composants générant de la chaleur sont disposés sur des côtés opposés du corps de refroidissement (1).

2. Module selon la revendication 1, **caractérisé en ce qu'**au moins un composant générant de la chaleur est relié en conduction thermique à une portion de la surface extérieure du corps de refroidissement (1).

3. Module selon l'une des revendications précédentes, **caractérisé en ce qu'**un composant générant de la chaleur est équipé sur une carte imprimée (23, 24, 25), sachant que la carte imprimée (23, 24, 25) est reliée au corps de refroidissement (1) au moyen d'un dispositif de maintien.

4. Module selon la revendication 3, **caractérisé en ce que** le dispositif de maintien est un élément électrique isolant (21) exerçant une pression sur la carte imprimée (23, 24, 25), élément qui est pressé sur la carte imprimée (23, 24, 25) par une plaque de maintien métallique (20).

5. Module selon la revendication 4, **caractérisé en ce que** la plaque de maintien (20) et l'élément isolant (21) sont disposés sur des côtés de la carte imprimée (23, 24, 25) qui sont éloignés du corps de refroidissement (1).

6. Module selon l'une des revendications précédentes, **caractérisé en ce que** le corps de refroidissement (1), afin d'améliorer le transfert de chaleur, est creusé. et/ou soumis à un usinage de finition dans la région (26) de la surface de contact (2) avec le ou les composants générant de la chaleur.

7. Module selon l'une des revendications précédentes, **caractérisé en ce qu'**au moins un élément (3, 4) de guidage d'air est disposé sur le corps de refroidissement (1),
sachant qu'un premier élément (3, 4) de guidage d'air comprend un ventilateur et un élément (3, 4) de guidage d'air espacé du premier élément (3, 4) de guidage d'air au moyen du corps de refroidissement (1) sert à maintenir le corps de refroidissement (1) sur une plaque de montage (42), sachant que l'élément supplémentaire (3, 4) de guidage d'air est disposé entre le corps de refroidissement (1) et la plaque de montage (42).

8. Module selon l'une des revendications précédentes, **caractérisé en ce que** le composant générant de la chaleur est un semi-conducteur de puissance,
et **en ce qu'**au moins un autre composant générant de la chaleur est présent, tel qu'une inductance dont le noyau de bobine est relié en conduction thermique au corps de refroidissement (1).

9. Module selon l'une des revendications précédentes, **caractérisé en ce que** la direction de traversée du corps de refroidissement (1) par la cavité est orientée perpendiculaire aux directions normales des cartes imprimées (23, 24, 25).

10. Module selon l'une des revendications précédentes, **caractérisé en ce que** des composants générant de la chaleur sont reliés en conduction thermique au corps de refroidissement (1) sur plusieurs portions planes de surface de ce dernier, sachant que les portions de surface ne sont pas orientées en parallèle et/ou sachant que les directions normales des portions de surface traversent la cavité.

11. Armoire de commande (40) dotée d'un boîtier,
sachant que le boîtier entoure un ou plusieurs modules selon l'une des revendications précédentes, formant ainsi un boîtier, et comprend au moins un élément (3, 4) de guidage d'air,
sachant que le ou chaque module est à ventilation centrale, donc présente un canal de refroidissement disposé dans le module et traversé par un agent de refroidissement, sachant que la ventilation centrale du ou de chaque module débouche dans un canal collecteur disposé à l'intérieur du boîtier,
sachant que le canal collecteur mène vers un élément (3, 4) de guidage d'air du boîtier, sachant que l'élément (3, 4) de guidage d'air présente une ouverture dirigée vers l'environnement,
sachant que le module présente un agencement de cartes imprimées, un corps de refroidissement (1) et des composants générant de la chaleur,
sachant que le corps de refroidissement (1) présente une cavité continue qui joue le rôle de canal de refroidissement,
sachant que l'agencement de cartes imprimées est un agencement de cartes imprimées (23, 24, 25) reliées au moyen de régions flexibles (26),
sachant que l'agencement entoure au moins partiellement le corps de refroidissement (1) dans la direction périphérique du canal de refroidissement,
sachant que deux cartes imprimées (23, 24, 25) reliées au moyen de régions flexibles (26) présentent chacune un composant générant de la chaleur, sachant que chacune des cartes imprimées présente un élément de maintien qui exerce une pression sur la carte imprimée par l'intermédiaire d'un élément isolant (21) et qui est respectivement relié par vissage au corps de refroidissement (1),
sachant que l'élément de maintien et l'élément isolant (21) sont respectivement disposés sur des côtés de la carte imprimée qui sont éloignés du corps de refroidissement (1), sachant que les deux composants générant de la chaleur sont disposés sur des côtés opposés du corps de refroidissement (1).

12. Armoire de commande (40) selon la revendication 11, **caractérisée en ce que** l'alimentation de la ventilation centrale s'effectue à partir d'une région intérieure du dispositif entourée par le boîtier,
et **en ce que** le boîtier présente un évidement par lequel la région intérieure peut être alimentée avec un flux d'agent de refroidissement.

13. Armoire de commande (40) selon l'une des revendications 12 ou 11, **caractérisée en ce qu'**une plaque de montage (42) est disposée à l'intérieur du boîtier entre la région intérieure et le canal collecteur,
sachant que la région intérieure est délimitée par rapport au canal collecteur au moyen d'une plaque de montage (42),
et **en ce que** les modules sont reliés à la plaque de montage (42).

14. Armoire de commande (40) selon l'une des revendications 11, 12 ou 13, **caractérisée en ce que** l'élément (3, 4) de guidage d'air présente une plaque de base sur laquelle sont disposées des nervures de refroidissement (30) tournées vers l'espace intérieur du dispositif,
de sorte que le flux d'agent de refroidissement sortant du canal collecteur est évacué dans l'environnement en passant le long des nervures de refroidissement (30),
sachant que le flux d'agent de refroidissement est ce faisant dévié, en particulier d'une direction pour l'essentiel verticale dans une direction pour l'essentiel horizontale.

15. Armoire de commande (40) selon l'une des revendications 11 à 14, **caractérisée en ce que** la plaque de montage (42) présente un évidement associé au module respectif et traversant la plaque de montage (42),
sachant que la région intérieure est délimitée par au moins la plaque de montage (42), le boîtier et la grille de ventilateur (43),
sachant que le canal collecteur est délimité par au moins la plaque de montage (42) et le boîtier.
